**Europäisches Patentamt**

**European Patent Office**

**Office européen des brevets**

(19)

(11) Veröffentlichungsnummer : **0 349 878 B1**

## (12) EUROPÄISCHE PATENTSCHRIFT

(45) Veröffentlichungstag der Patentschrift :
**16.09.92 Patentblatt 92/38**

(51) Int. Cl.$^5$ : **H05K 7/14**

(21) Anmeldenummer : **89111615.4**

(22) Anmeldetag : **26.06.89**

(54) **Elektronik-Baugruppe.**

(30) Priorität : **07.07.88 DE 8808743 U**

(43) Veröffentlichungstag der Anmeldung :
**10.01.90 Patentblatt 90/02**

(45) Bekanntmachung des Hinweises auf die
Patenterteilung :
**16.09.92 Patentblatt 92/38**

(84) Benannte Vertragsstaaten :
**AT CH DE ES FR GB IT LI SE**

(56) Entgegenhaltungen :
**DE-A- 2 843 710
DE-U- 1 984 651
MACHINE DESIGN vol. 56, no. 25, 8 November
1984, Cleveland, Ohio, US Seite 58 "Steel
snap-in replaces plastic"**

(73) Patentinhaber : **SIEMENS
AKTIENGESELLSCHAFT
Wittelsbacherplatz 2
W-8000 München 2 (DE)**

(72) Erfinder : **Eibl, Erwin
Otto-Carl-Schulz-Strasse 17
W-8450 Amberg (DE)**
Erfinder : **Schmidt, Heinz, Dipl.-Ing. (FH)
Drosselgasse 5
W-8457 Kümmersbruck (DE)**
Erfinder : **Rester, Heribert, Dipl.-Ing. (FH)
Sportplatzstrasse 10
W-8468 Steinberg (DE)**

EP 0 349 878 B1

**Beschreibung**

Die Erfindung betrifft eine Elektronik-Baugruppe, bestehend aus mindestens zwei parallel angeordneten, mit elektrischen Bauteilen, die nur auf einer Seite mit elektrischen Bauelementen bestückt sind, und Leiterbahnen versehenen Bauelementeträgern, wobei jeweils ein Bauelementeträger mit mindestens einem anderen Bauelementeträger durch mindestens einen Abstandshalter verbunden ist, wobei die Bauteile jeweils auf der Innenseite zweier durch Abstandshalter verbundener Bauelementeträger aufrecht nebeneinander angeordnet sind und mindestens zwischen einem Teil der Bauteile eines ersten Bauelementeträgers Zwischenräume bestehen, in die jeweils mindestens ein Bauteil des anderen Bauelementeträgers hineinragt.

Eine derartige Baugruppe ist aus dem DE-U-l9 84 65l bekannt. Die Subkarten liegen jedoch hier allseitig an, wodurch eine ausgeglichene Wärmeverteilung zwischen den Subkarten verhindert wird. Außerdem werden die Subkarten hier so angeordnet, daß ihre Seiten mit den Leiterbahnen dicht nebeneinander stehen, um für die anderen mit Bauelementen besetzten Seiten der Subkarten mehr Platz zu erhalten. Eine derartige Ausführung birgt jedoch eine erhöhte Gefahr eines Kurzschlusses zwischen Subkarten in sich.

Aus dem DE-U-l9 62 067 ist eine Elektronik-Baugruppe der genannten Art bekannt. Hier sind mehrere Trägerplatten mit Bauelementen übereinander paketiert. Die Trägerplatten sind durch flexible Leiterplatten verbunden, die zur elektrischen Verschaltung dienen. Dies ist zwar eine kompakte Bauform, bei der jedoch keine Hybride verwendet werden und die somit offenläßt, wie mit Hybriden bestückte Trägerplatten wenig Raum beanspruchend anzuordnen sind.

Der Erfindung liegt daher die Aufgabe zugrunde, eine Baugruppe so zu gestalten, daß auf geringem Raum viele elektrische Bauteile kurzschlußsicher und unter Herstellung einer möglichst gleichmäßigen Verteilung der Verlustwärme untergebracht werden. Diese Aufgabe wird dadurch gelöst, daß

a) die elektrischen Bauteile Hybride sind, deren unbestückte Seite vollständig isolierend ausgebildet ist,
b) zwischen den Hybriden und den jeweils gegenüberliegenden Bauelementeträgern Zwischenräume bestehen und
c) die isolierenden Oberflächen der verschachtelt angeordneten Hybride alle derselben Seite zugewandt sind.

Durch diese Ausführung ergeben sich außerdem folgende Vorteile: Die zur Verschachtelung der Hybride dienenden Zwischenräume ermöglichen, die Hybride zu überprüfen und Bauelemente auf ihnen auszutauschen. Die verschachtelte Anordnung der Hybride erweist sich auch dadurch als vorteilhaft, daß zwischen zwei Hybriden mit größerer Verlustleistung ein entsprechend großer Zwischenraum gelassen werden kann, in dem dann ein anderes Hybrid mit kleinerer Verlustleistung Platz findet, womit eine bessere Wärmeverteilung erreicht wird.

Sind die Zwischenräume zwischen den Hybriden kanalartig, so ergibt sich hierdurch, insbesondere bei senkrechter Ausrichtung der Kanäle, eine gute Abfuhr der Verlustwärme.

Sind zwei Bauelementeträger, die jeweils mit einer Abstandsmittel aufweisenden, elektrischen Anschlußleiste versehen sind, über die Abstandsmittel mechanisch verbindbar, so ist hierdurch mit geringem Aufwand eine Abstandshalterung geschaffen, bei der ohnehin vorhandene elektrische Anschlußleisten vorteilhaft benutzt werden.

Ein weiterer Vorteil ergibt sich, wenn ein erstes Abstandsmittel ein rohrförmiges Teil mit einem schlitzartigen Durchbruch aufweist und das Gegenstück bildende Abstandsmittel aus einem stiftförmigen, in das rohrförmige Teil einsteckbaren Teil besteht, das an seinem freien Ende geschlitzt ist und in den Durchbruch einrastbare Rastvorsprünge aufweist. Hierdurch ist eine einen Abstand fixierende Abstandshalterung möglich, indem das stiftförmige Teil in das rohrförmige Teil bis zum Einrasten eingeschoben wird. Diese Raststellung läßt sich jedoch durch Auseinanderziehen der Abstandsmittel leicht wieder lösen.

Es ist vorteilhaft, wenn die Bauelementeträger elektrische Anschlußmittel aufweisen, da über diese ein Signalaustausch zwischen den Bauteilen der Bauelementeträger in einfacher Weise vorgenommen werden kann. Dieser Signalaustausch über hierfür vorgesehene Anschlußmittel ist deshalb von besonderem Nutzen, weil in manchen Fällen nur wenig oder gar kein Platz mehr auf den Bauelementeträgern für die hierfür ansonsten notwendigen Leiterbahnen existiert.

Im folgenden wird ein Ausführungsbeispiel anhand der Zeichnung näher erläutert. Es zeigen:

FIG l eine Seitenansicht der Elektronik-Baugruppe,
FIG 2 die Abstandsmittel auf den elektrischen Anschlußleisten,
FIG 3 einen Abstandshalter.

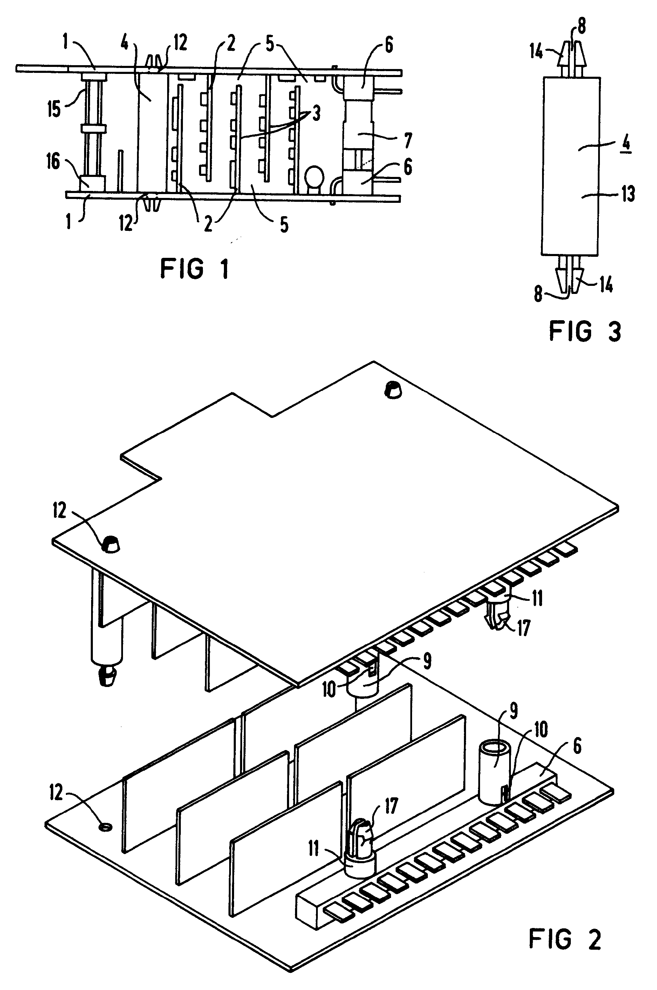

FIG l zeigt eine aus zwei parallel angeordneten Bauelementeträgern l bestehende Elektronik-Baugruppe. Die Bauelementeträger l weisen jeweils eine elektrische Anschlußleiste 6 auf, an der Abstandsmittel 7 angeformt sind. Über die Abstandsmittel 7 und über Abstandshalter 4 lassen sich die beiden Bauelementeträger l in festem Abstand zueinander zusammensetzen. Die Abstandshalter 4 stecken im zusammengefügten Zustand in Öffnungen l2 der Bauelementeträger l und lassen sich durch Zusammendrücken an ihren geschlitzten Enden aus den Öffnungen l2 leicht herauslösen. Auf beiden Bauelementeträgern l sind neben anderen Bauelementen auf der jeweils dem anderen Bauelementeträger l zugewandten Seite senkrecht zum Bauelementeträger l stehende Hybride 2 angelötet, die über Leiterbahnen auf der anderen Seite des betreffenden Bauelementeträgers l mit anderen Bauelementen verschaltet sind. Die Hybride 2 sind nur auf einer Seite mit elektrischen Bauelementen bestückt und weisen auf der anderen Seite eine isolierende Oberfläche 3 auf. Die Hybride 2 des einen Bauelementeträgers l sind so angeordnet, daß sich kanalartige Zwischenräume 5 zwischen ihnen befinden, in die jeweils ein Hybrid 2 des anderen Bauelementeträgers l hineinragt. Durch die kanalartigen Zwischenräume 5 läßt sich die Verlustwärme besonders gut abführen, wenn diese ähnlich einem Kamin senkrecht ausgerichtet sind, wobei bei einem die Elektronik-Baugruppe umschließenden Gehäuse oben und unten zugehörige Durchzugöffnungen vorzusehen sind. Die beiden Bauelementeträger l lassen sich über elektrische Anschlußmittel, z.B. einer Messerleiste l5 an dem einen Bauelementeträger l und einer entsprechenden Federleiste l6 an dem anderen Bauelementeträger l, elektrisch verschalten.

FIG 2 zeigt die elektrischen Anschlußleisten 6 mit den daran angeformten Abstandsmitteln 7 zweier Bauelementeträger l in perspektivischer Darstellung. Die Abstandsmittel 7 bestehen aus zwei ineinandersteckbaren Teilen 9 und ll. Das Teil 9 ist rohrförmig und weist einen schlitzartigen Durchbruch l0 auf. Das zylinderförmige Teil ll ist an seinem freien Ende, das mit zwei Rastvorsprüngen l7 versehen ist, geschlitzt. Es läßt sich in das Teil 9 einschieben und seine Rastvorsprünge l7 rasten dabei in den Durchbruch l0 ein, womit eine Fixierung der Stellung bewirkt wird. Die Rastvorsprünge l7 sind derart abgeschrägt, daß die Raststellung in dem Durchbruch l0 durch Auseinanderziehen des rohrförmigen 9 und des zylinderförmigen Teils ll gelöst werden kann.

FIG 3 zeigt einen Abstandshalter 4, bestehend aus einem Mittelteil l3 und zwei mit Rastmitteln, hier Rastnasen l4, und einem Schlitz 8 versehenen Enden. Zur Verbindung zweier Bauelementeträger l durch Abstandshalter 4 sind entsprechende Öffnungen, in diesem Ausführungsbeispiel Löcher l2, vorgesehen, in die die Rastnasen l4 eingerastet werden. Dadurch, daß die Enden des Abstandshalters 4 geschlitzt sind, lassen sich die Rastnasen l4 zusammendrücken, wodurch sich der Abstandshalter 4 aus den Löchern l2 leicht lösen läßt.

## Patentansprüche

1. Elektronik-Baugruppe, bestehend aus mindestens zwei parallel angeordneten, mit elektrischen Bauteilen (2), die nur auf einer Seite mit elektrischen Bauelementen bestückt sind, und Leiterbahnen versehenen Bauelementeträgern (l), wobei jeweils ein Bauelementeträger (l) mit mindestens einem anderen Bauelementeträger (l) durch mindestens einen Abstandshalter (4) verbunden ist, wobei die Bauteile (2) jeweils auf der Innenseite zweier durch Abstandshalter (4) verbundener Bauelementeträger (l) aufrecht nebeneinander angeordnet sind und mindestens zwischen einem Teil der Bauteile (2) eines ersten Bauelementeträgers (l) Zwischenräume (5) bestehen, in die jeweils mindestens ein Bauteil (2) des anderen Bauelementeträgers (l) hineinragt, **dadurch gekennzeichnet** , daß

a) die elektrischen Bauteile Hybride (2) sind, deren unbestückte Seite vollständig isolierend ausgebildet ist,

b) zwischen den Hybriden (2) und den jeweils gegenüberliegenden Bauelementeträgern (l) Zwischenräume bestehen und

c) die isolierenden Oberflächen (3) der verschachtelt angeordneten Hybride (2) alle derselben Seite zugewandt sind.

2. Elektronik-Baugruppe nach Anspruch l, **dadurch gekennzeichnet,** daß die Zwischenräume (5) zwischen den Hybriden (2) kanalartig sind.

3. Elektronik-Baugruppe nach einem der vorhergehenden Ansprüche, **dadurch gekennzeichnet,** daß zwei Bauelementeträger (l), die jeweils mit einer Abstandsmittel (7) aufweisenden elektrischen Anschlußleiste (6) versehen sind, über die Abstandsmittel (7) mechanisch verbindbar sind.

4. Elektronik-Baugruppe nach einem der vorhergehenden Ansprüche, **dadurch gekennzeichnet,** daß ein erstes Abstandsmittel (7) ein rohrförmiges Teil (9) mit einem schlitzartigen Durchbruch (l0) aufweist und daß das Gegenstück bildende Abstandsmittel (7) aus einem stiftförmigen, in das rohrförmige Teil (9) einsteckbaren Teil (ll) besteht, das an seinem freien Ende geschlitzt ist und in den Durchbruch (l0) einrastbare Rastvorsprünge (17) aufweist.

5. Elektronik-Baugruppe nach einem der vorhergehenden Ansprüche, **dadurch gekennzeichnet,** daß die Bauelementeträger (l) elektrische Anschlußmittel aufweisen.

## Claims

1. Electronics module comprising at least two component carriers (1) arranged in parallel and provided with electrical assemblies (2) which are equipped on one side only with electrical structural elements, and strip conductors, one component carrier (1) being respectively connected to at least one other component carrier (1) by at least one range spacer (4), the assemblies (2) each being arranged perpendicularly next to each other on the inside of two component carriers (1) joined by range spacers (4), and intermediate spaces (5) existing at least between some of the assemblies (2) of a first component carrier (1) into which spaces at least one assembly (2) of the other component carrier (1) projects, characterised in that

   a) the electrical assemblies are hybrids (2) whose unequipped side is constructed to be completely insulating,
   b) between the hybrids (2) and the respectively opposite component carriers (1) intermediate spaces exist and
   c) the insulating surfaces (3) of the hybrids (2) arranged in interleaved manner all face the same side.

2. Electronics module according to claim 1, characterised in that the intermediate spaces (5) between the hybrids (2) are duct-like.

3. Electronics module according to one of the preceding claims, characterised in that two component carriers (1), which are respectively provided with an electrical contact strip (6) having spacer means (7), can be mechanically connected via the spacer means (7).

4. Electronics module according to one of the preceding claims, characterised in that a first spacer means (7) has a tubular portion (9) with a slit-like opening (10) and in that spacer means (7) forming the counter piece comprise a pin-shaped portion (11) which can be inserted into the tubular portion (9) and has slits at its free end and stop projections (17) which can engage into the opening (10).

5. Electronics module according to one of the preceding claims, characterised in that the component carriers (1) have electrical connecting means.

## Revendications

1. Groupe électronique constitué par au moins deux porte-composants (1) disposés en parallèle et pourvus de modules électriques (2), dont seule une face est pourvue de composants électriques, et de voies conductrices, et dans lequel respectivement un porte-composants (1) est raccordé à au moins un autre porte-composants (1) par au moins une entretoise (4), les modules (2) étant respectivement disposés verticalement côte-à-côte sur la face interne de deux porte-composants (1) raccordés par des entretoises (4), tandis qu'au moins entre une partie des modules (2) d'un premier porte-composants (1), il existe des espaces intercalaires (5), dans lesquels pénètre respectivement au moins un module (2) de l'autre porte-composants (1), caractérisé par le fait que

   a) les modules électriques sont des circuits hybrides (2), dont la face non équipée est agencée de manière à être entièrement isolante,
   b) des espaces intercalaires existent entre les circuits hybrides (2) et les porte-composants (1) situés respectivement en vis-à-vis, et
   c) les surfaces isolantes (3) des circuits hybrides (2) disposés en position imbriquée, sont toutes tournées du même côté.

2. Groupe électronique suivant la revendication 1, caractérisé par le fait que les espaces intercalaires (5) entre les circuits hybrides (2), possèdent la forme de canaux.

3. Groupe électronique suivant l'une des revendications précédentes, caractérisé par le fait que deux porte-composants (1), qui comportent respectivement une barrette de raccordement électrique (6) possédant des moyens d'entretoisement (7), peuvent être raccordés mécaniquement par l'intermédiaire des moyens d'entretoisement (7).

4. Groupe électronique suivant l'une des revendications précédentes, caractérisé par le fait qu'un premier moyen d'entretoisement (7) possède une pièce tubulaire (9) comportant un passage en forme de fente (10) et que le moyen d'entretoisement (7), qui constitue la pièce antagoniste, est constitué par une partie en forme de tige (11), qui peut être enfichée dans la pièce tubulaire (9), est fendue à son extrémité libre et possède des appendices d'encliquetage saillants (17) pouvant s'encliqueter dans le passage (10).

5. Groupe électronique suivant l'une des revendications précédentes, caractérisé par le fait que les porte-composants (1) possèdent des moyens de raccordement électrique.

FIG 1

FIG 3

FIG 2